# EUROPEAN PATENT SPECIFICATION

(11) **EP 3 925 993 B1**
(45) Date of publication and mention of the grant of the patent: **13.09.2023**
(21) Application number: 20755435.3
(22) Date of filing: 22.01.2020
(51) Int. Cl.: C08F 290/06, G03F 7/027, C08F 2/50, C08F 222/10, C09D 151/08, C09D 4/06

(54) **PHOTOCURABLE RESIN COMPOSITION AND CURED PRODUCT OBTAINED BY CURING SAME**
FOTOHÄRTBARE HARZZUSAMMENSETZUNG UND DURCH DEREN HÄRTUNG HERGESTELLTES GEHÄRTETES PRODUKT
COMPOSITION DE RÉSINE PHOTODURCISSABLE ET OBJET DURCI OBTENU PAR SON DURCISSEMENT

(30) Priority: 12.02.2019 US 201962804337 P
(43) Date of publication of application: 22.12.2021
(73) Proprietor: Namics Corporation, Niigata-shi, Niigata 950-3131 (JP)
(72) Inventor: CZUBAROW, Pawel, Wellesley, Massachusetts 02482 (US); SATO, Toshiyuki, Niigata-shi, Niigata 950-3131 (JP); OTOMO, Masayoshi, Niigata-shi, Niigata 950-3131 (JP)
(74) Representative: Hoffmann Eitle
(86) International application number: PCT/JP2020/002100
(87) International publication number: WO 2020/166288

(56) References cited:
- WO-A1-2005/073264
- WO-A1-2016/104748
- WO-A1-2017/135168
- WO-A1-2017/135168
- WO-A1-2018/030112
- WO-A1-2019/130735
- JP-A- 2003 515 642
- JP-A- 2006 513 301
- JP-A- 2007 112 826
- JP-A- 2017 047 648
- JP-A- 2018 028 078
- US-A1- 2012 125 672

## Description

### Technical Field

The present invention relates to a photocurable resin composition suitable as an insulating material for wiring, to a cured product obtained by curing the composition, and to a wiring structure, an electronic part and a semiconductor device comprising a cured product obtained by curing the composition.

### Background Art

In recent years, a wiring structure constituting an electronic part, such as an integrated circuit, is extremely finely wired. This brings extremely narrow spacing between external terminals through which a semiconductor chip comprising such a wiring structure is connected to an outside wiring.

Such an electronic part is used after it is mounted on a printed circuit board or the like. The spacing between the positions for connecting the above-mentioned external terminals, the spacing set on a printed circuit board, cannot be reduced below a certain level due to various restrictions. For this reason, a redistribution layer is formed on the surface of a semiconductor chip and, typically, external terminals called bumps are formed on the redistribution layer. The spacing between the bumps is matched to the spacing between the connection positions on the printed circuit board, and the bumps and the semiconductor chip are connected through a wiring provided in the redistribution layer.

The redistribution layer is composed of these wirings and an insulating material and, as a typical method of patterning for forming the wiring, photolithography is conventionally known. When the patterning is carried out by photolithography, a photocurable resin composition is used to form such a redistribution layer.

Currently, a photosensitive polyimide precursor composition is frequently used as an insulating material for forming a redistribution layer. A redistribution layer comprising a polyimide resin can be produced by applying this composition to the surface of a semiconductor chip to thereby form a thin film, and subjecting the obtained thin film to patterning by photolithography followed by treatment at a high temperature of not less than 200°C. The polyimide resin obtained by curing the photosensitive polyimide precursor composition exhibits high heat resistance and mechanical characteristics, and is excellent also in electrical characteristics, such as dielectric characteristics, thus being suitable as a material for a redistribution layer. Such a photosensitive polyimide precursor composition is described, for example, in Patent Literatures 1 and 2.

Another example of curable composition from the prior art is WO2018030112A1 which describes a composition comprising a poly(phenylene ether) resin having a radical-polymerizable substituent.

### Citation List

### Patent Literature

Patent Literature 1: Japanese Patent Application Kokai Publication No. 2004-294882
Patent Literature 2: Japanese Patent Application Kokai Publication No. 2009-186861

### Summary of the Invention

### Problem to Be Solved by the Invention

However, conversion of the polyimide precursor in the above-mentioned composition to a polyimide resin requires high-temperature treatment at 200°C or above. In the formation of a redistribution layer using the photosensitive polyimide precursor composition, this high-temperature treatment is performed after photolithographic patterning, and the formed pattern is deformed by shrinkage occurring during this high-temperature treatment. Thus, there has been a problem that when a photosensitive polyimide precursor composition is used as a material for forming a redistribution layer, the desired pattern is not accurately reproduced.

In recent years, wirings in a redistribution layer are also becoming finer, and there is a growing demand of L/S of 2 µm or less. Under such circumstances, the above-mentioned shrinkage deformation during the high-temperature treatment is becoming a major problem.

In order to solve the above-mentioned problems in the art, an object of the present invention is to provide a photocurable resin composition that can accurately reproduce a desired fine wiring pattern without problems, such as deformation due to high-temperature treatment, and is suitable as a material for forming, for example, a redistribution layer in an electronic part.

### Means for Solving the Problem

The present inventors carried out extensive studies to solve the above problems, and have consequently arrived at the present invention.

That is, the present invention includes, but is not limited to, the following inventions.
1. A photocurable resin composition comprising the following components (A) to (D):
   (A) a modified polyphenylene ether resin represented by the following formula (1): 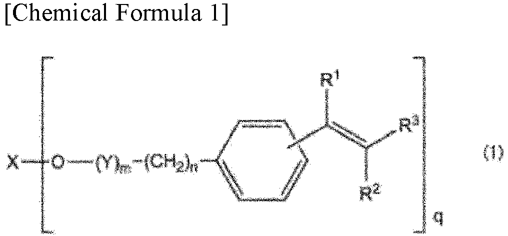 [wherein:
      R¹ to R³ each independently represent a hydrogen atom, an alkyl group, an alkenyl group or an alkynyl group,
      X represents a q-valent, unsubstituted or substituted aromatic hydrocarbon group,
      Y represents an unsubstituted or substituted phenol repeating unit represented by the following formula (2): 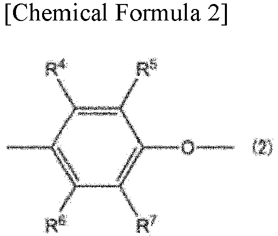
      [wherein R⁴ to R⁷ each independently represent a hydrogen atom, an alkyl group, an alkenyl group, an alkynyl group or an alkenylcarbonyl group],
      m represents an integer of 1 to 100,
      n represents an integer of 1 to 6, and
      q represents an integer of 1 to 4];
   (B) a bifunctional acrylic resin represented by the following formula (3): 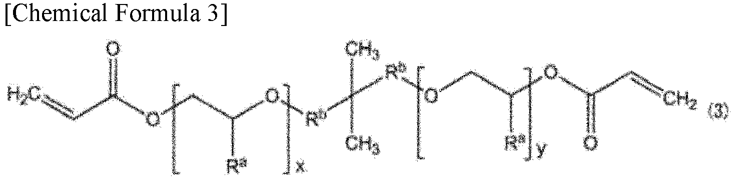 [wherein
      each R^{a} independently represents a hydrogen atom or a methyl group,
      each R^{b} independently represents a divalent hydrocarbon group, and
      x and y each independently represent an integer of 1 to 5];
   (C) a photopolymerization initiator; and
   (D) a coupling agent,
   wherein the mass ratio of the component (A) to the component (B) is 74.9:25.1 to 49.9:50.1.
2. The photocurable resin composition according to item 1 above, which further comprises the following component (E):
   (E) a film-forming agent.
3. The photocurable resin composition according to item 1 or 2 above, wherein the number average molecular weight of the component (A) is not less than 500 and not more than 5000.
4. The photocurable resin composition according to any one of items 1 to 3 above, wherein the component (C) is selected from the group consisting of an acylphosphine oxide photopolymerization initiator and an oxime ester photopolymerization initiator.
5. The photocurable resin composition according to any one of items 1 to 4 above, wherein the component (D) is a silane coupling agent.
6. A film comprising the photocurable resin composition according to any one of items 2 to 5 above.
7. A cured product obtained by curing the photocurable resin composition of any one of items 1 to 5 above or the film of item 6 above.
8. A wiring structure comprising the cured product of item 7 above.
9. An electronic part comprising the cured product of item 7 above.
10. A semiconductor device comprising the electronic part of item 9 above.

### Effects of the Invention

The photocurable resin composition of the present invention comprises a specific modified polyphenylene ether resin, a specific bifunctional acrylic resin, a photopolymerization initiator and a coupling agent in a specific ratio. Curing of the photocurable resin composition can be achieved satisfactorily by irradiation with a common active energy ray (for example, ultraviolet ray) without requiring high-temperature treatment. Thus, the photocurable resin composition is free from problems such as deformation due to high-temperature treatment. A cured product obtained by such curing is excellent in properties such as electrical characteristics (especially dielectric characteristics), heat resistance, and adhesion to other materials. Thus, the photocurable resin composition of the present invention may be suitably used as a material for producing an electronic part that constitute a semiconductor device, particularly, as a material for forming a redistribution layer.

### Brief Description of Drawings

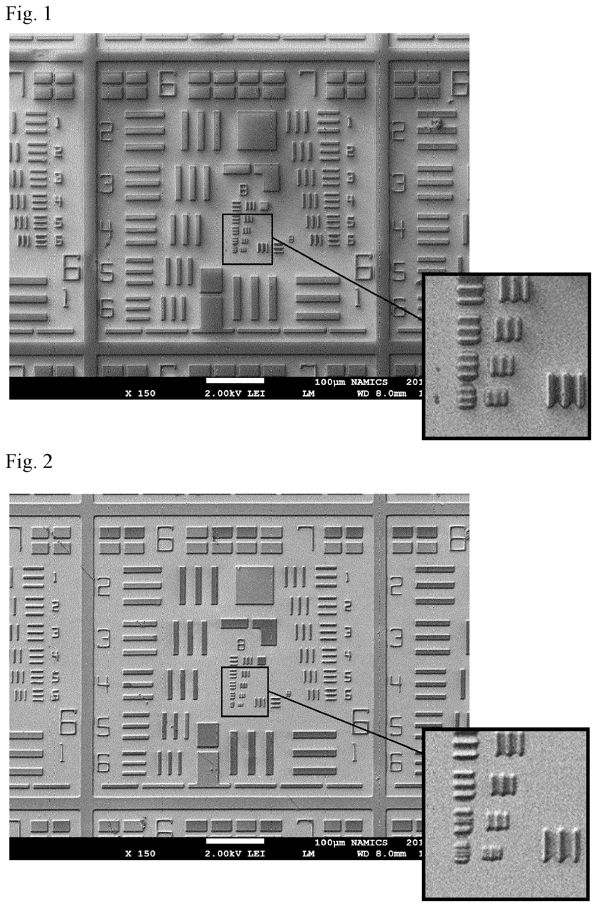

[Fig. 1] Fig. 1 is an electron micrograph (magnification: 150 times) of a pattern formed by photolithographically patterning the photocurable resin composition of Example 1.
[Fig. 2] Fig. 2 is an electron micrograph (magnification: 150 times) of a pattern formed by photolithographically patterning the photocurable resin composition of Example 5.

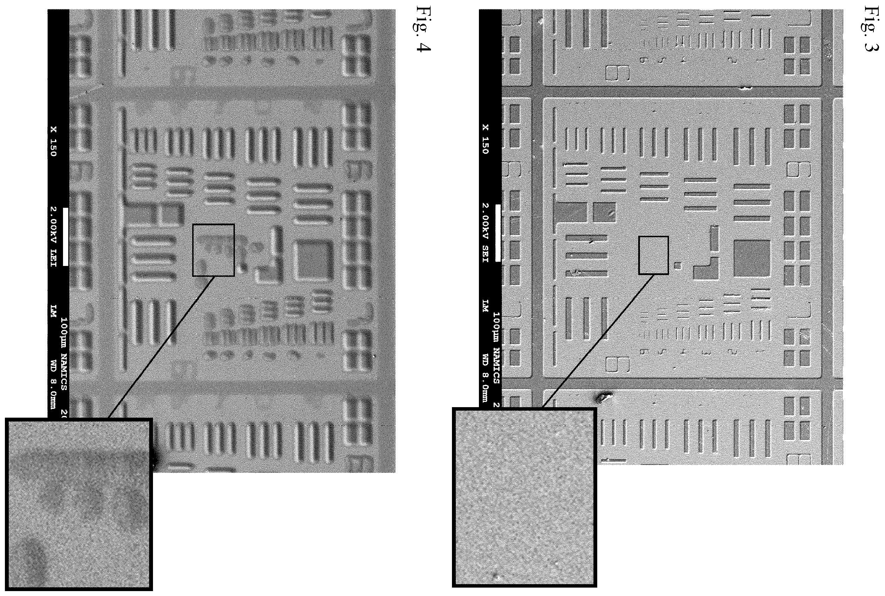

[Fig. 3] Fig. 3 is an electron micrograph (magnification: 150 times) of a pattern formed by photolithographically patterning the photocurable resin composition of Comparative Example 1.
[Fig. 4] Fig. 4 is an electron micrograph (magnification: 150 times) of a pattern formed by photolithographically patterning the photocurable resin composition of Comparative Example 7.

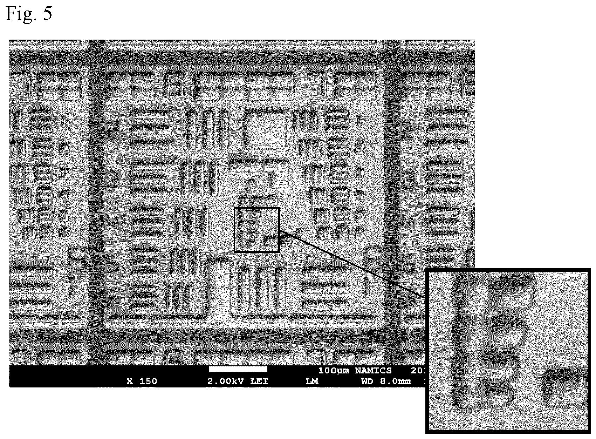

[Fig. 5] Fig. 5 is an electron micrograph (magnification: 150 times) of a pattern formed by photolithographically patterning the photocurable resin composition of Comparative Example 8.

### Description of Embodiments

Hereinbelow, embodiments of the present invention will be described in detail.

The present invention relates to a photocurable resin composition comprising the following components (A) to (D):
(A) a modified polyphenylene ether resin;
(B) a bifunctional acrylic resin;
(C) a photopolymerization initiator; and
(D a coupling agent,
wherein the mass ratio of the component (A) to the component (B) being 74.9:25.1 to 49.9:50.1. The components (A) to (D) that are contained in the photocurable resin composition of the present invention will be described below.

### [Modified polyphenylene ether resin (component (A))]

The photocurable resin composition of the present invention contains a specific modified polyphenylene ether (PPE) resin represented by the following formula (1): 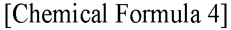 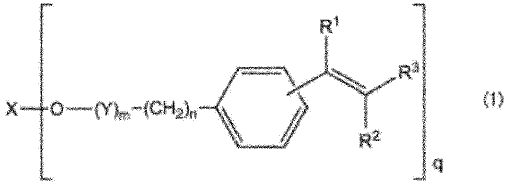 [wherein
R¹ to R³ each independently represent a hydrogen atom, an alkyl group, an alkenyl group or an alkynyl group,
X represents a q-valent, unsubstituted or substituted aromatic hydrocarbon group,
Y represents an unsubstituted or substituted phenol repeating unit represented by the following formula (2): 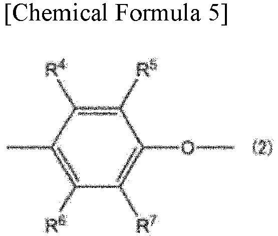 [wherein R⁴ to R⁷ each independently represent a hydrogen atom, an alkyl group, an alkenyl group, an alkynyl group or an alkenylcarbonyl group],
m represents an integer of 1 to 100,
n represents an integer of 1 to 6, and
q represents an integer of 1 to 4]. This modified PPE resin may be hereinafter referred to as the "component (A)".

In general, an x-valent (x represents an integer of 1 or greater) hydrocarbon group means a group with a valence of x generated by removing x hydrogen atom(s) from a carbon atom(s) of a hydrocarbon. Thus, the above-mentioned q-valent, unsubstituted or substituted aromatic hydrocarbon group means a monovalent to tetravalent group generated by removing 1 to 4 hydrogen atom(s) from a carbon atom(s) of an aromatic hydrocarbon which may be substituted or unsubstituted.

The term "alkyl group" means a monovalent saturated hydrocarbon group. In the present invention, the alkyl group is preferably a C₁-C₁₀ alkyl group, more preferably a C₁-C₆ alkyl group, still more preferably a C₁-C₄ alkyl group, and particularly preferably a C₁-C₂ alkyl group. Examples of such alkyl groups include methyl group, ethyl group, propyl group, isopropyl group, butyl group, isobutyl group, sec-butyl group, tert-butyl group, pentyl group, hexyl group and the like.

The term "alkenyl group" means a monovalent unsaturated hydrocarbon group having at least one carbon-carbon double bond. In the present invention, the alkenyl group is preferably a C₂-C₁₀ alkenyl group, more preferably a C₂-C₆ alkenyl group, and still more preferably a C₂-C₄ alkenyl group. Examples of such alkenyl groups include ethenyl group (vinyl group), 1-propenyl group, 2-propenyl group, 1-butenyl group, 2-butenyl group, isobutenyl group, 1-pentenyl group, 1-hexenyl group and the like. Further, the group -CR¹=CR²R³ in formula (1) above is also an alkenyl group.

The term "alkynyl group" means an unsaturated hydrocarbon group having at least one carbon-carbon triple bond. In the present invention, the alkynyl group is preferably a C₂-C₁₀ alkynyl group, more preferably a C₂-C₆ alkynyl group, and still more preferably a C₂-C₄ alkynyl group. Examples of such alkynyl groups include ethynyl group, 1-propynyl group, 2-propynyl group, butynyl group, isobutynyl group, pentynyl group, hexynyl group and the like.

The term "alkenylcarbonyl group" means a carbonyl group substituted with the above-mentioned alkenyl group. Examples thereof include acryloyl group, methacryloyl group and the like.

In the component (A), the moiety represented by -(Y)ₘ- corresponds to the main chain of the PPE resin. Preferably, in the above-mentioned unsubstituted or substituted phenol repeating unit Y, R⁴ and R⁶ each represent a hydrogen atom and R⁵ and R⁷ each represent a methyl group. One end of the moiety represented by -(Y)ₘ- is bonded to the above-mentioned aromatic hydrocarbon group X via an oxygen atom, and the other end is bonded, via n methylene group(s), to the phenyl group substituted with the above-mentioned alkenyl group -CR¹=CR²R³. The alkenyl group -CR¹=CR²R³ may be located at any of the ortho position, the meta position and the para position with respect to the above-mentioned methylene group(s). In an embodiment, n in formula (1) is an integer of 1 to 4. In another embodiment, n in formula (1) is 1 or 2. In another embodiment, n in formula (1) is 1. In another embodiment, each of R¹ to R³ in formula (1) is a hydrogen atom.

The number m of the repeating units Y is preferably 1 to 80, more preferably 1 to 30, and still more preferably 1 to 5.

In the component (A), q moieties represented by -(Y)ₘ- are bonded to the above-mentioned aromatic hydrocarbon group X, each via an oxygen atom. Preferably, q is 2 or 3. More preferably, q is 2. Preferably, X has a structure represented by the following formula: 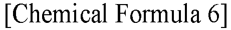 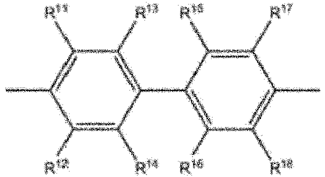 [wherein R¹¹ to R¹⁸ each independently represent a hydrogen atom or a C₁-C₆ alkyl group].

More preferably, X has a structure represented by the following formula:

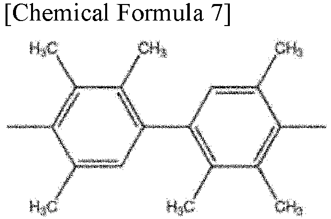

From the viewpoint of the fluidity at the time of shaping of the photocurable resin composition of the present invention, the dielectric characteristics and heat resistance of cured products obtained by curing the composition, the compatibility with other components added to the composition, and the like, the number average molecular weight of the component (A) is preferably not less than 500 and not more than 5000. An excessively low number average molecular weight of the component (A) may lead to decrease in the toughness of cured products obtained by curing the photocurable resin composition of the present invention. On the other hand, when the number average molecular weight of the component (A) is excessively high, the component (A) exhibits low compatibility with other components, especially a solvent that is optionally added. Consequently, it becomes difficult to control, by the addition of a solvent, the viscosity of the photocurable resin composition of the present invention to a level suited for spin coating, and the like. The number average molecular weight of the component (A) is more preferably not less than 750 and not more than 3000, and still more preferably not less than 1000 and not more than 2500. The number average molecular weight of the component (A) may be measured by a known method, for example, gel permeation chromatography.

The content of the component (A) in the photocurable resin composition of the present invention is not particularly limited, but is preferably 0.1 to 30 parts by mass, more preferably 0.5 to 20 parts by mass, and still more preferably 1 to 15 parts by mass, with respect to 100 parts by mass of the photocurable resin composition of the present invention.

The component (A) is available as a commercial product (for example, OPE 2St 1200 (manufactured by MITSUBISHI GAS CHEMICAL COMPANY, INC.).

Alternatively, the component (A) may be prepared by a known method. For example, the component (A) may be prepared by a method that comprising oxidatively copolymerizing, by a known method, an appropriate q-valent phenol having a structure represented by X-(OH)_{q} (wherein X and q have the same meanings as described above) (such as (2,2',3,3',5,5')-hexamethylbiphenyl-4,4'-diol) and an appropriate monovalent phenol having a structure represented by the following formula: 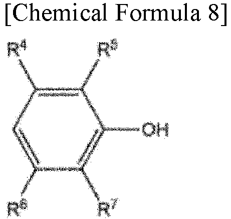 [wherein R⁴ to R⁷ have the same meanings as described above]
(such as 2,6-dimethylphenol) to thereby prepare a polyphenylene ether resin having a hydroxyl group at a terminal, and modifying the resin by reacting the resin with an appropriate modifier, for example, chloromethylstyrene.

Alternatively, the component (A) may be prepared using, as a raw material, a polyphenylene ether resin having a number average molecular weight higher than that of the component (A) (for example, more than 10,000), in accordance with the method described in Japanese Patent Application Kokai Publication No. 2008-260941, for example.

### [Bifunctional acrylic resin (component (B))]

The photocurable resin composition of the present invention contains a bifunctional acrylic resin represented by the following formula (3): 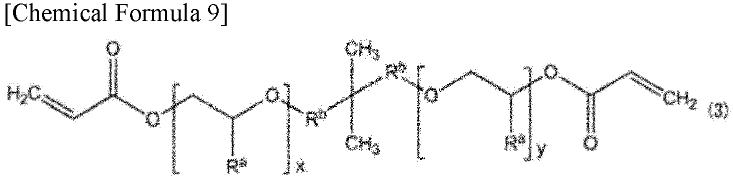 [wherein
each R^{a} independently represents a hydrogen atom or a methyl group,
each R^{b} independently represents a divalent hydrocarbon group, and
x and y each independently represent an integer of 1 to 5]. This specific bifunctional acrylic resin may be hereinafter referred to as the "component (B)".

The component (B) used in the present invention reacts, by the action of the photopolymerization initiator described later, with the modified PPE resin (the component (A)) described above and cures the resin (hereinafter, this reaction is sometimes written as the "curing reaction"). Further, by the use of the component (B), the heat resistance or the like of the cured product obtained by curing photocurable resin composition of the present invention is maintained, even though the component (A) with a low molecular weight is used for enhancing the fluidity of the composition. In the present invention, the resin used as the components (B) can be used individually or in combination.

In the present invention, the fact that the component (B) is bifunctional, i.e., has two acryloyloxy groups has great significance.

A resin composition comprising a monofunctional acrylic resin (an acrylic resin having one acryloyloxy group) is not satisfactorily cured even when subjected to curing treatment under conditions wherein the photocurable resin composition of the present invention is satisfactorily cured.

On the other hand, a resin composition that comprises an acrylic resin having three or more acryloyloxy groups is also not satisfactorily cured even when subjected to curing treatment under conditions wherein the photocurable resin composition of the present invention is satisfactorily cured. In other cases, such a resin composition exhibits unsatisfactory affinity to a substrate. These phenomena were first discovered by the present inventors.

The reasons of these phenomena are not clear. However, it is inferred that these phenomena are associated with the fact that in an acrylic resin having three or more acryloyloxy groups, the probability of participation in the curing reaction of all of the acryloyloxy groups present in one molecule is low.

The photocurable resin composition of the present invention has excellent film-forming properties and gives a uniform thin film by a relatively simple film forming method, such as spin coating. It is inferred that also these excellent film-forming properties are associated with the fact that the component (B) is bifunctional.

In an embodiment, each R^{b} in formula (3) independently is a methylene group or a p-phenylene group. In another embodiment, in formula (3), R^{b} is a methylene group and R^{a} is a methyl group. In another embodiment, in formula (3), R^{b} is a p-phenylene group and R^{a} is a hydrogen atom.

Examples of compounds usable as the components (B) include, but are not limited to, ethoxylated bisphenol A diacrylate (diacrylate of bisphenol A to which (poly)ethylene glycol is bonded), propoxylated bisphenol A diacrylate (diacrylate of bisphenol A to which (poly)propylene glycol is bonded), ethoxylated neopentyl glycol diacrylate (diacrylate of neopentyl glycol to which (poly)ethylene glycol is bonded), and propoxylated neopentyl glycol diacrylate (diacrylate of neopentyl glycol to which (poly)propylene glycol is bonded). These may be used individually or in combination.

In the photocurable resin composition of the present invention, the mass ratio of the component (A) to the component (B) is 74.9:25.1 to 49.9:50.1. A photocurable resin composition with the mass ratio of the component (A) to the component (B) outside of the above range gives a cured product having unsatisfactory adhesion to a substrate when cured on the substrate.
In the photocurable resin composition of the present invention, the mass ratio of the component (A) to the component (B) is particularly preferably 66.7:33.3 to 50.2:49.8.

The content of the component (B) in the photocurable resin composition of the present invention is not particularly limited, but is preferably 20 to 50 parts by mass, more preferably 25 to 50 parts by mass, and still more preferably 30 to 47 parts by mass, with respect to 100 parts by mass of the photocurable resin composition of the present invention.

The component (B) is available as a commercial product (for example, SR601 and SR9003B (manufactured by ARKEMA)).

Alternatively, the component (B) may be prepared by a known method. For example, the component (B) may be prepared by a method comprising reacting an appropriate diol compound having a structure represented by (CH₃)₂C(R^{b}OH)₂ (wherein R^{b} has the same meaning as described above) with ethylene oxide or propylene oxide, and reacting the resultant product with acrylic acid or a derivative thereof.

### [Photopolymerization initiator (component (C))]

The photocurable resin composition of the present invention contains a photopolymerization initiator. The photopolymerization initiator may be hereinafter referred to as the "component (C)". The component (C) used in the present invention is not particularly limited as long as it is a compound that, upon irradiation with an active energy ray, generates radicals or the like and thereby cures the components (A) and (B). The active energy rays include all kinds of light in a broad sense, such as radiations including α rays and β rays, electromagnetic waves including y rays and X rays, electron beams (EB), ultraviolet light with wavelength of about 100 to 400 nm, and visible light with wavelength of about 400 to 800 nm, with ultraviolet light being preferable. In the present invention, the compounds used as the components (C) may be used individually or in combination.

Examples of the components (C) include acetophenone photopolymerization initiators, benzoin photopolymerization initiators, benzophenone photopolymerization initiators, thioxanthone photopolymerization initiators, acylphosphine oxide photopolymerization initiators, oxime ester photopolymerization initiators, titanocene photopolymerization initiators and the like. Among these, acylphosphine oxide photopolymerization initiators and oxime ester photopolymerization initiators are preferable. These may be used individually or in combination.

Examples of the above-mentioned acylphosphine oxide photopolymerization initiators include, but are not limited to, bis(2,4,6-trimethylbenzoyl)-phenyl-phosphine oxide, 2,4,6-trimethylbenzoyl-diphenyl-phosphine oxide and the like.

Examples of the above-mentioned oxime ester photopolymerization initiators include, but are not limited to, 1-[9-ethyl-6-(2-methylbenzoyl)-9H-carbazol-3-yl]-ethanone 1-(O-acetyloxime), 1-[4-(phenylthio)phenyl]-1,2-octanedione 2-(O-benzoyloxime) and the like.

The amount of the component (C) in the photocurable resin composition of the present invention is not particularly limited, but is preferably 0.1 to 30 parts by mass, more preferably 0.25 to 10 parts by mass, and particularly preferably 0.5 to 5 parts by mass, with respect to 100 parts by mass of the photocurable resin composition of the present invention. When the amount of the component (C) is excessively small, the photocurable resin composition of the present invention is not satisfactorily cured and exhibits low adhesion to a substrate. On the other hand, when the amount of the component (C) is excessively large, the photocurable resin composition of the present invention is cured to an excessive extent. Therefore, when a thin film obtained by subjecting the composition to film-making is subjected to patterning by photolithography, the curing proceeds even in masked portions and, consequently, reproduction of a fine pattern becomes difficult.

The component (C) is available as a commercial product (for example, IRGACURE TPO, IRGACURE 819, IRGACURE 819DW, IRGACURE OXE01 and IRGACURE OXE02 (manufactured by BASF)).

### [Coupling agent (component (D))]

The photocurable resin composition of the present invention contains a coupling agent. The coupling agent has two or more different functional groups in the molecule. One of such functional groups is a functional group capable of forming a chemical bond with an inorganic material, and another is a functional group capable of forming a chemical bond with an organic material. The presence of the coupling agent contained in the photocurable resin composition of the present invention is critical in order for the composition to exhibit satisfactory adhesion to other materials. The coupling agent may be hereinafter referred to as the "component (D)".

Examples of the components (D) include, but are not limited to, silane coupling agents, aluminum coupling agents, titanium coupling agents and the like. In the present invention, the compounds serving as the components (D) may be used individually or in combination.

In the present invention, the component (D) is preferably a silane coupling agent. Examples of the functional groups present in the silane coupling agents include vinyl group, epoxy group, styryl group, methacrylic group, acrylic group, amino group, isocyanurate group, ureido group, mercapto group, sulfide group, isocyanate group and the like.

The amount of the component (D) in the photocurable resin composition of the present invention is not particularly limited, but is preferably 0.1 to 30 parts by mass, more preferably 0.5 to 10 parts by mass, and particularly preferably 0.8 to 3 parts by mass, with respect to 100 parts by mass of the photocurable resin composition of the present invention. When the amount of the component (D) is excessively small, the photocurable resin composition of the present invention fails to exhibit satisfactory adhesion to a substrate. On the other hand, when the amount of the component (D) is excessively large, voids, bleedout and the like may occur.

The component (D) is available as a commercial product (for example, KBM 503 and KBM 1003 (manufactured by Shin-Etsu Silicone) and Coatosil MP200 (manufactured by Momentive Performance Materials Japan)).

If desired, the photocurable composition of the present invention may comprise optional components as appropriate, for example, a film-forming agent described below, in addition to the components (A) to (D).

### [Film-forming agent (component (E))]

If desired, a film-forming agent may be added to the photocurable composition of the present invention. A film comprising the photocurable composition of the present invention may be obtained by forming the photocurable composition of the present invention into a film by a known method. Such a film facilitates placing of the photocurable composition of the present invention at a position where a redistribution layer is formed, and thus contributes to enhancing the workability in the formation of a redistribution layer. A film-forming agent imparts flexibility to the photocurable composition of the present invention. Addition of a film-forming agent facilitates obtaining a film comprising the photocurable composition of the present invention and handling such a film. The film-forming agent may be hereinafter referred to as the "component (E)".

Examples of the components (E) include, but are not limited to, phenoxy resins and acrylic resins. The phenoxy resins are polyhydroxy polyethers synthesized by direct reaction of a dihydric phenol compound with epichlorohydrin or by addition polymerization reaction of a diglycidyl ether of a divalent phenol compound with a divalent phenol compound. An acrylic resin is a homopolymer or copolymer of acrylic acid and/or methacrylic acid, or a derivative thereof (for example, an ester and amide).

The amount of the component (E) in the photocurable resin composition of the present invention is not particularly limited.

The component (E) is available a commercial product (for example, bisphenol A phenoxy resin 4250 (manufactured by Mitsubishi Chemical Corporation), bisphenol A phenoxy resin Fx316 (manufactured by NIPPON STEEL & SUMITOMO METAL CORPORATION), bisphenol A phenoxy resin YP50 (manufactured by NIPPON STEEL & SUMITOMO METAL CORPORATION), and polymethyl methacrylate/butyl acrylate triblock copolymer M52N (manufactured by ARKEMA)).

The photocurable resin composition of the present invention may further comprise optional components other than the components (E), such as stabilizers, fillers, pigments, plasticizers, flame retardants, ion trapping agents, antifoaming agents, leveling agents, foam breakers, solvents and the like, without impairing the advantageous effects of the present invention.

### [Photocurable resin composition]

The photocurable resin composition of the present invention may be prepared by mixing the components described hereinabove. The components may be mixed by a known device, such as a Henschel mixer or a roll mill. The components may be mixed at the same time, or part of the components may be mixed first and the remaining part of the components may be mixed later.

The photocurable resin composition of the present invention obtained as described above may be easily cured by irradiation with the active energy ray described above, preferably light having a wavelength of 10 nm to 600 nm, more preferably an ultraviolet ray having a wavelength of 100 nm to 500 nm, still more preferably an ultraviolet ray having a wavelength of 250 nm to 450 nm, and particularly preferably an ultraviolet ray having a wavelength of 300 nm to 400 nm. The curing temperature is usually 0°C to 100°C, preferably 10°C to 50°C, and more preferably 15°C to 35°C. The irradiation time may vary depending on the curing temperature, the volume of the resin composition to be cured and the like, but is usually 5 seconds to 60 minutes. The cured product obtained as described above has excellent properties, such as electrical characteristics (especially dielectric characteristics), heat resistance and adhesion to other materials. Thus, the photocurable resin composition of the present invention may be suitably used as a material for producing an electronic part that constitute a semiconductor device, for example, a material for an interlayer insulating film, a substrate and the like.

The photocurable resin composition of the present invention has excellent film-forming properties and gives a uniform thin film by a relatively simple film forming method, such as spin coating. When a thin film obtained by subjecting the photocurable resin composition of the present invention to film-making is subjected to patterning by photolithography, even a fine pattern is successfully reproduced. Further, the photocurable resin composition of the present invention can be cured satisfactorily by irradiation with an active energy ray (in particular, ultraviolet ray), and treatment of the patterned thin film at high temperature (for example, 200°C or above) is not necessary. Therefore, the photocurable resin composition is free from problems, such as deformation of a wiring pattern formed by patterning due to shrinkage or the like occurring during such a high-temperature treatment.

A cured product obtained by curing the photocurable resin composition of the present invention is excellent in heat resistance as well as in dielectric characteristics. Even when the cured product after photolithographic patterning is subjected to a treatment at a high temperature of about 200°C, the formed pattern is not deformed by this heat, as long as the treatment time is up to about 1 hour. By virtue of such characteristics, the photocurable resin composition of the present invention is suitable as a material for an electronic part that constitute a semiconductor device, particularly as a material for forming a redistribution layer in a wiring structure of an electronic part.

The present invention also provides a cured product obtained by curing the photocurable resin composition of the present invention or by curing a film comprising the composition. The present invention also provides a wiring structure comprising the cured product of the present invention, an electronic part comprising the cured product of the present invention, and a semiconductor device comprising the electronic part of the present invention.

### EXAMPLES

Hereinbelow, Examples and Comparative Examples of the present invention will be described. The scope of the present invention is not limited to those Examples and Comparative Examples below. In Examples and Comparative Examples, the amounts of components contained in the photocurable resin compositions are indicated as mass (unit: g).

### [Preparation of photocurable resin compositions]

The following are raw materials of photocurable resin compositions used in Examples and Comparative Examples below.

### Modified polyphenylene ether resin (component (A))

In Examples and Comparative Examples, the following compound was used as the component (A).

(A-1): OPE 2St 1200 (modified polyphenylene ether resin having vinyl groups at both ends (reaction product of 2,2',3,3',5,5'-hexamethylbiphenyl-4,4'-diol·2,6-dimethylphenol polycondensate and chloromethylstyrene, number average molecular weight: 1160 (manufactured by MITSUBISHI GAS CHEMICAL COMPANY, INC.) ·Bifunctional acrylic resin (component (B))

In Examples and Comparative Examples, the following compounds were used as the components (B).
(B-1): SR9003B (propoxylated neopentyl glycol diacrylate (manufactured by ARKEMA))
(B-2): SR601 (ethoxylated bisphenol A diacrylate (manufactured by ARKEMA))

### ·Trifunctional acrylic resin (component (B'))

In Examples and Comparative Examples, the following compound was used as the component (B').

(B'-1): SR9053 (trifunctional acid ester (manufactured by ARKEMA)) ·Photopolymerization initiator (component (C))

In Examples and Comparative Examples, the following compounds were used as the components (C).
(C-1): IRGACURE OXE02 (oxime ester photopolymerization initiator (manufactured by BASF))
(C-2): IRGACURE 819 (acylphosphine oxide photopolymerization initiator (manufactured by BASF))

### ·Coupling agent (component (D))

In Examples and Comparative Examples, the following compounds were used as the components (D).
(D-1): KBM 503 (3-methacryloxypropyltrimethoxysilane (manufactured by Shin-Etsu Silicone))
(D-2): KBM 1003 (vinyltrimethoxysilane (manufactured by Shin-Etsu Silicone))
(D-3): Coatosil MP200 (epoxy group-modified silane coupling agent (manufactured by Momentive Performance Materials Japan))

### Examples 1 to 7 and Comparative Examples 1 to 8

In accordance with the formulations described in Table 1, photocurable resin compositions were prepared by mixing the components in predetermined amounts using a planetary centrifugal mixer (ARE-310 manufactured by THINKY).

The photocurable resin compositions obtained were each applied on a 150 mm diameter silicon wafer by spin-coating using a spin coater (WS-650-8B (manufactured by Laurell)) (conditions: 12 seconds at 500 rpm and 20 seconds at 1500 rpm (acceleration: 1200)). The silicon wafers were dried by heating in air atmosphere at 120°C for 5 minutes to give samples each composed of the silicon wafer and a 4.81 µm thick uniform thin film formed on the silicon wafer.

The samples were subjected to the following photolithography test to evaluate the suitability of the photocurable resin compositions for photolithography. The results are described in Table 1.

### [Photolithography test]

A mask (1.5 mm thick, USAF pattern manufactured by Advance Reproductions) was placed on the surface of the thin film of the sample described above, and the sample was subjected to irradiation with an ultraviolet ray under the conditions described below, with the mask in close contact with the thin film surface. The mask had a large number of rectangular (450 µm × 450 µm) regions, and these regions had identical wiring patterns drawn therein. Each of the wiring patterns included a plurality of sub-patterns having various L/S values, one of which consisted of three lines with L/S = 2 µm.

### (Ultraviolet irradiation conditions)

Ultraviolet irradiation device: Bluewave (registered trademark) QX4 (manufactured by DYMAX)
(Equipped with LED head RediCure (trademark) (manufactured by DYMAX) as a light source)
Ultraviolet wavelength: 365 nm
Irradiation intensity: Approximately 200 mW/cm²
Irradiation time: 10 seconds
Mask-light source distance: 50 mm

### After the completion of ultraviolet irradiation, the mask was removed from the sample. The sample was washed with cyclopentanone three times and was dried by heating in air atmosphere at 200°C for 1 hour. After the completion of drying, the surface of the thin film in the sample was observed with a scanning electron microscope (magnification: 150 times) to examine whether the wiring pattern had been clearly reproduced on the thin film. The suitability of the photocurable resin composition for photolithography was evaluated as "good" when the sub-patterns described above consisting of three lines with L/S = 2 µm had been clearly reproduced on the thin film. The suitability was evaluated as "poor" when these sub-patterns had not been clearly reproduced on the thin film.

### [Table 1-1]

**Table 1**

| | | Compara-t ive Example 1 | Example 1 | Example 2 | Example 3 | Example 4 | Compara-t ive Example 2 | Compara-t ive Example 3 | Compara-t ive Example 4 |
|---|---|---|---|---|---|---|---|---|---|
| Component (A) | (A-1) | 45.50 | 46.83 | 46.35 | 63.41 | 57.81 | 72.32 | 63.11 | 71.89 |
| Component (B) | (B-1) | 47.35 | 46.51 | 46.53 | 31.68 | 19.41 | 24.03 | 15.91 | 12.04 |
| | (B-2) | | | | | 19.78 | | 16.16 | 12.13 |
| Compo-ne nt (B') | (B'-1) | | | | | | | | |
| Component (C) | (C-1) | 4.74 | 4.63 | 4.72 | 3.26 | 1.98 | 2.52 | 3.21 | 2.39 |
| | (C-2) | | | | | | | | |
| Component (D) | (D-1) | | 2.04 | | 1.65 | 1.02 | | 1.61 | 1.55 |
| | (D-2) | 2.41 | | 2.41 | | | 1.13 | | |
| | (D-3) | | | | | | | | |
| (A)/(A)+(B) ^{a} | | 49.0% | 50.2% | 49.9% | 66.7% | 74.9% | 75.1% | 79.9% | 85.7% |
| (B)/(A)+(B) ^{b} | | 51.0% | 49.8% | 50.1% | 33.3% | 25.1% | 24.9% | 20.1% | 14.3% |
| Evaluation ^{c} | | Poor | Good | Good | Good | Good | Poor | Poor | Poor |

| | | | | | | | | | |
|---|---|---|---|---|---|---|---|---|---|
| a: Mass of component (A) x 100 / (mass of component (A) + mass of component(s) (B)) (%) b: Mass of component(s) (B) x 100 / (mass of component (A) + mass of component(s) (B)) (%) c: Evaluation by photolithography test | | | | | | | | | |

### [Table 1-2]

**Table 1 (continued)**

| | | Example 5 | Compara-t ive Example 5 | Compara-t ive Example 6 | Compara-t ive Example 7 | Compara-t ive Example 8 | Example 6 | Example 7 |
|---|---|---|---|---|---|---|---|---|
| Component (A) | (A-1) | 46.17 | 71.35 | 63.17 | 58.07 | 46.23 | 46.26 | 46.26 |
| Component (B) | (B-1) | 23.08 | | | | | 23.33 | 23.33 |
| | (B-2) | 23.41 | | | | | 23.20 | 23.20 |
| Compo-ne nt (B') | (B'-1) | | 24.56 | 31.68 | 38.99 | 46.05 | | |
| Component (C) | (C-1) | 4.91 | 2.76 | 3.22 | 1.97 | 4.83 | 4.59 | |
| | (C-2) | | | | | | | 4.59 |
| Component (D) | (D-1) | 2.43 | 1.33 | 1.93 | 0.97 | 2.90 | | |
| | (D-2) | | | | | | | |
| | (D-3) | | | | | | 2.62 | 2.62 |
| (A)/(A)+(B) ^{a} | | 66.7% | 74.4% | 66.6% | 59.8% | 50.1% | 66.5% | 66.5% |
| (B)/(A)+(B) ^{b} | | 33.3% | 25.6% | 33.4% | 40.2% | 49.9% | 33.5% | 33.5% |
| Evaluation ^{c} | | Good | Poor | Poor | Poor | Poor | Good | Good |

| | | | | | | | | |
|---|---|---|---|---|---|---|---|---|
| a: Mass of component (A) x 100 / (mass of component (A) + mass of component(s) (B)) (%) b: Mass of component(s) (B) x 100 / (mass of component (A) + mass of component(s) (B)) (%) c: Evaluation by photolithography test | | | | | | | | |

### (Discussion of results)

Each of the photocurable resin compositions with the mass ratio of the component (A) to the component (B) within the range of 74.9:25.1 to 49.9:50.1 was cured satisfactorily by ultraviolet irradiation under the above conditions, and each of the resultant cured products exhibited satisfactory adhesion to the substrate (silicon wafer) (Examples 1 to 7). On the other hand, each of the photocurable resin compositions with the mass ratio of the component (A) to the component (B) outside of the above-mentioned range (Comparative Examples 1 to 4) gave a cured product having unsatisfactory adhesion to a substrate when cured on the substrate. Therefore, the resin composition was excessively removed during the above-mentioned washing with cyclopentanone, and the sub-patterns consisting of three lines with L/S = 2 µm was failed to be reproduced on the thin film.

When an acrylic resin having three acryloyloxy groups was used in place of the component (B) (having two acryloyloxy groups), the resin composition was not satisfactorily cured by ultraviolet irradiation under the conditions described above (Comparative Examples 5 to 7), or the resin composition exhibited unsatisfactory affinity to the substrate and was repelled from the substrate (Comparative Example 8). These problems were not solved even when the mass ratio of the component (A) to the component (B) was changed.

### Industrial Applicability

Curing of the photocurable resin composition of the present invention can be achieved satisfactorily by irradiation with common active energy rays (for example, ultraviolet rays) without requiring high-temperature treatment. Thus, the photocurable resin composition is free from problems such as deformation due to high-temperature treatment. A cured product obtained by such curing is excellent in properties such as electrical characteristics (especially dielectric characteristics), heat resistance, and adhesion to other materials. Thus, the photocurable resin composition of the present invention may be suitably used as a material for producing an electronic part that constitutes a semiconductor device, particularly as a material for forming a redistribution layer.

## Claims

1. A photocurable resin composition comprising the following components (A) to (D):
(A) a modified polyphenylene ether resin represented by the following formula (1): 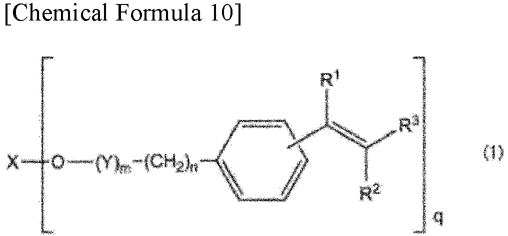 [wherein:
R¹ to R³ each independently represent a hydrogen atom, an alkyl group, an alkenyl group or an alkynyl group,
X represents a q-valent, unsubstituted or substituted aromatic hydrocarbon group,
Y represents an unsubstituted or substituted phenol repeating unit represented by the following formula (2): 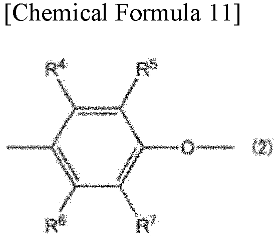 [wherein R⁴ to R⁷ each independently represent a hydrogen atom, an alkyl group, an alkenyl group, an alkynyl group or an alkenylcarbonyl group],
m represents an integer of 1 to 100,
n represents an integer of 1 to 6, and
q represents an integer of 1 to 4];
(B) a bifunctional acrylic resin represented by the following formula (3): 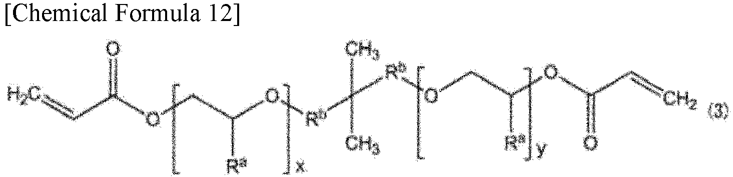 [wherein:
each R^{a} independently represents a hydrogen atom or a methyl group,
each R^{b} independently represents a divalent hydrocarbon group, and
x and y each independently represent an integer of 1 to 5];
(C) a photopolymerization initiator; and
(D) a coupling agent,
wherein the mass ratio of the component (A) to the component (B) is 74.9:25.1 to 49.9:50.1.

2. The photocurable resin composition according to Claim 1, which further comprises the following component (E):
(E) a film-forming agent.

3. The photocurable resin composition according to Claim 1 or 2, wherein the number average molecular weight of the component (A) is not less than 500 and not more than 5000.

4. The photocurable resin composition according to any one of Claims 1 to 3, wherein the component (C) is selected from the group consisting of an acylphosphine oxide photopolymerization initiator and an oxime ester photopolymerization initiator.

5. The photocurable resin composition according to any one of Claims 1 to 4, wherein the component (D) is a silane coupling agent.

6. A film comprising the photocurable resin composition of any one of Claims 2 to 5.

7. A cured product obtained by curing the photocurable resin composition of any one of Claims 1 to 5 or the film of Claim 6.

8. A wiring structure comprising the cured product of Claim 7.

9. An electronic part comprising the cured product of Claim 7.

10. A semiconductor device comprising the electronic part of Claim 9.

## Patentansprüche

1. Photohärtbare Harzzusammensetzung, umfassend die folgenden Komponenten (A) bis (D):
(A) ein modifiziertes Polyphenylenetherharz, dargestellt durch die folgende Formel (1): 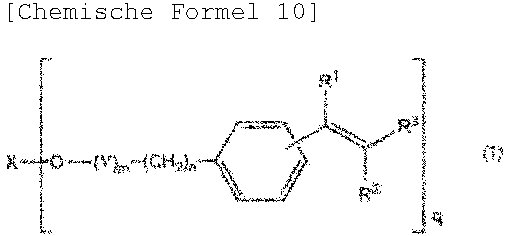 worin
R¹ bis R³ jeweils unabhängig ein Wasserstoffatom, eine Alkylgruppe, eine Alkenylgruppe oder eine Alkinylgruppe darstellen,
X eine q-wertige, unsubstituierte oder substituierte aromatische Kohlenwasserstoffgruppe darstellt,
Y eine unsubstituierte oder substituierte Phenol-Wiederholungseinheit darstellt, die durch die folgende Formel (2) dargestellt wird: 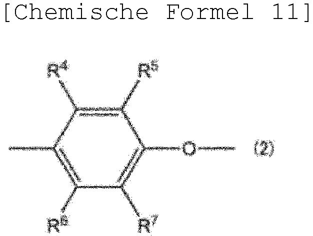 worin R⁴ bis R⁷ jeweils unabhängig ein Wasserstoffatom, eine Alkylgruppe, eine Alkenylgruppe, eine Alkinylgruppe oder eine Alkenylcarbonylgruppe darstellen,
m eine ganze Zahl von 1 bis 100 darstellt,
n eine ganze Zahl von 1 bis 6 darstellt, und
q eine ganze Zahl von 1 bis 4 darstellt;
(B) ein bifunktionelles Acrylharz, dargestellt durch die folgende Formel (3): 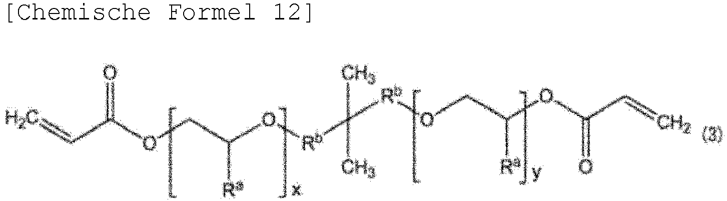 worin:
jedes R^{a} unabhängig ein Wasserstoffatom oder eine Methylgruppe darstellt,
jedes R^{b} unabhängig eine zweiwertige Kohlenwasserstoffgruppe darstellt, und
x und y jeweils unabhängig eine ganze Zahl von 1 bis 5 darstellen];
(C) einen Photopolymerisationsinitiator; und
(D) ein Kupplungsmittel,
wobei das Massenverhältnis der Komponente (A) zu der Komponente (B) 74,9:25,1 bis 49,9:50,1 beträgt.

2. Photohärtbare Harzzusammensetzung gemäß Anspruch 1, die ferner die folgende Komponente (E) umfasst:
(E) ein filmbildendes Mittel.

3. Photohärtbare Harzzusammensetzung gemäß Anspruch 1 oder 2, wobei das zahlenmittlere Molekulargewicht der Komponente (A) nicht weniger als 500 und nicht mehr als 5000 beträgt.

4. Photohärtbare Harzzusammensetzung gemäß mindestens einem der Ansprüche 1 bis 3, wobei die Komponente (C) ausgewählt ist aus einer Gruppe bestehend aus einem Acylphosphinoxid-Photopolymerisationsinitiator und einem Oximester-Photopolymerisationsinitiator.

5. Photohärtbare Harzzusammensetzung gemäß mindestens einem der Ansprüche 1 bis 4, wobei die Komponente (D) ein Silankupplungsmittel ist.

6. Film, umfassend die photohärtbare Harzzusammensetzung gemäß mindestens einem der Ansprüche 2 bis 5.

7. Gehärtetes Produkt, erhältlich durch Härten der photohärtbaren Harzzusammensetzung gemäß mindestens einem der Ansprüche 1 bis 5 oder des Films gemäß Anspruch 6.

8. Verdrahtungsstruktur, umfassend das gehärtete Produkt gemäß Anspruch 7.

9. Elektronisches Bauteil, umfassend das gehärtete Produkt gemäß Anspruch 7.

10. Halbleiterbauelement, umfassend das elektronische Bauteil gemäß Anspruch 9.

## Revendications

1. Composition de résine photodurcissable comprenant les composants suivants (A) à (D) :
(A) une résine polyphénylène éther modifiée représentée par la formule suivante (1) : 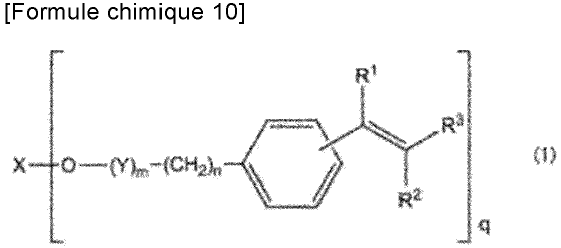 [dans laquelle :
R¹ à R³ représentent chacun indépendamment un atome d'hydrogène, un groupe alkyle, un groupe alcényle ou un groupe alcynyle,
X représente un groupe hydrocarbure aromatique non substitué ou substitué q-valent,
Y représente une unité de répétition phénol non substituée ou substituée représentée par la formule suivante (2) : 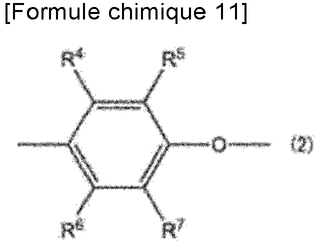 [dans laquelle R⁴ à R⁷ représentent chacun indépendamment un atome d'hydrogène, un groupe alkyle, un groupe alcényle, un groupe alcynyle ou un groupe alcénylcarbonyle],
m représente un entier de 1 à 100,
n représente un entier de 1 à 6, et
q représente un entier de 1 à 4] ;
(B) une résine acrylique bifonctionnelle représentée par la formule suivante (3) : 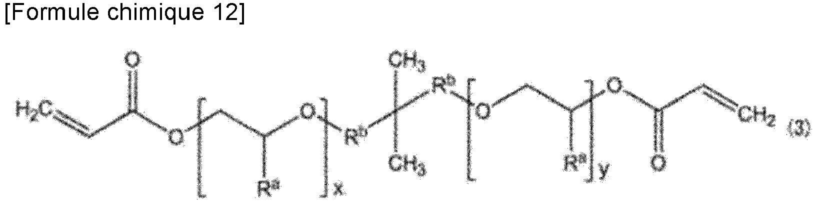 [dans laquelle :
chaque R^{a} représente indépendamment un atome d'hydrogène ou un groupe méthyle,
chaque R^{b} représente indépendamment un groupe hydrocarbure divalent, et
x et y représentent chacun indépendamment un entier de 1 à 5] ;
(C) un initiateur de photopolymérisation ; et
(D) un agent de couplage,
dans lequel le ratio en masse du composant (A) par rapport au composant (B) est dans une plage de 74,9:25,1 à 49,9:50,1.

2. Composition de résine selon la revendication 1, comprenant en outre le composant (E) suivant :
(E) un agent de formation de film.

3. Composition de résine photodurcissable selon la revendication 1 ou la revendication 2, dans laquelle le poids moléculaire moyen en nombre du composant (A) n'est pas inférieur à 500 et pas supérieur à 5000.

4. Composition de résine photodurcissable selon l'une quelconque des revendications 1 à 3, dans laquelle le composant (C) est sélectionné parmi le groupe composé d'un initiateur de photopolymérisation à l'oxyde d'acylphosphine et d'un initiateur de photopolymérisation d'ester d'oxime.

5. Composition de résine photodurcissable selon l'une quelconque des revendications 1 à 4, dans laquelle le composant (D) est un agent de couplage silane.

6. Film comprenant la composition de résine photodurcissable selon l'une quelconque des revendications 2 à 5.

7. Produit durci obtenu en durcissant la composition de résine photodurcissable selon l'une quelconque des revendications 1 à 5 ou le film selon la revendication 6.

8. Structure de câblage comprenant le produit durci selon la revendication 7.

9. Pièce électronique comprenant le produit durci selon la revendication 7.

10. Dispositif à semi-conducteurs comprenant la pièce électronique selon la revendication 9.
